# EUROPEAN PATENT SPECIFICATION

(11) **EP 4 199 664 B1**
(45) Date of publication and mention of the grant of the patent: **11.02.2026**
(21) Application number: 21214518.9
(22) Date of filing: 14.12.2021
(51) Int. Cl.: H05K 7/14, H05K 7/20

(54) **MULTI-MODULE CONVERTER WITH IMPROVED COOLING**
MEHRMODULWANDLER MIT VERBESSERTER KÜHLUNG
CONVERTISSEUR MULTI-MODULES À REFROIDISSEMENT AMÉLIORÉ

(43) Date of publication of application: 21.06.2023
(73) Proprietor: ABB SCHWEIZ AG, 5400 Baden (CH)
(72) Inventor: Drofenik, Uwe, 8053 Zürich (CH); Baumann, David, 5503 Schafisheim (CH); Rothmund, Daniel, 5243 Mülligen (CH); Canales, Francisco, 5405 Baden-Dättwil (CH); Costa, Levy, 5430 Wettingen (CH)
(74) Representative: Sykora & König Patentanwälte PartG mbB

(56) References cited:
- DE-A1- 2 718 967
- US-A- 3 573 574
- US-A- 3 646 400
- US-A- 3 697 814
- US-A1- 2014 374 394
- US-B1- 6 262 906

## Description

### FIELD OF THE INVENTION

The invention relates to a semiconductor module and a converter assembly.

### BACKGROUND OF THE INVENTION

For unidirectional AC/DC conversion of several Megawatts connected to a medium voltage grid (for example for fast charging, processing, drives for pumps and blowers, datacenters), often 12-pulse rectifiers and line-frequency transformers are employed.

In order to significantly reduce footprint, weight and cost, one can connect a diode rectifier directly to the grid with a medium frequency transformer in a second stage. State-of-the-art medium-voltage rectifier diodes for such applications are multi-cell structures, where each cell provides a diode which are all series-connected. Such solutions, although in the low-cost range, usually are not optimized for high power density and/or currents of more than a few tens of Amperes.

In such multi-cell structures, besides a diode each cell may comprise protection like varistors and snubbers, which are all series-connected to equally share the total blocking voltage in the range of tens of kV. Often, no heat sinks for the diodes are provided so that mainly the relative small semiconductor device surface is available for convection cooling which significantly limits the current, and, therefore, the rectifier power density. Sometimes, heat sinks are mounted onto each diode but the airflow along the fins is blocked by structures required for mechanical stability or electrical functionality (such as printed circuit boards). Furthermore, since air insulation requires large distances in medium voltage (10 cm and more, dependent on the voltages) and no air flow guidance is provided, the air flow goes mainly through the open insulation spaces instead of along the heat sink fins. This results in very poor fan utilization, significant current limitation, and low power density.

US 3 697 814 A shows a bridge rectifier heat sink assembly according to the preamble of the independent claim 1, said assembly comprising diodes, which are attached to a terminal board. The diodes are cooled by heat sinks, which are attached to the terminal board. An insulating plate with openings is attached to the heat sinks opposite to the terminal board.

US 3 646 400 A shows an air-cooling system for an HVDC valve with staggered rectifiers. Panel boards with diodes are arranged in a housing in a special way to support an air flow throw the panel boards. The diodes are mounted to electrodes with cooling ducts. The electrodes are mounted to the panel boards, which are made of electrical insulating material and which have apertures for allowing an cooling air flow through the cooling ducts.

US 2014/374394 A1 relates to integrated electrical components of a welding power supply. Semiconductors are mounted to a circuit board. Heat sinks are mounted to the semiconductors and protrude over a border of the printed circuit board.

### DESCRIPTION OF THE INVENTION

It is an objective of the invention to increase the rectifier power density and more general a converter power density for an air cooled converter, while still keeping the component cost in the range of low-cost solutions. Further objectives of the invention are to increase the modularity, the flexibility, the scalability and the maintenance friendliness of air cooled converters.

These objectives are achieved by the subject-matter of the independent claims. Further exemplary embodiments are evident from the dependent claims and the following description.

A first aspect of the invention relates to a semiconductor module. A semiconductor module is an assembly for electrically and mechanically interconnecting semiconductor devices, such as diodes, transistors, thyristors, etc. and optionally electrical devices such as resistors, capacitors, varistors, etc. The semiconductor module may be a medium voltage module adapted for processing voltages of about 10 kV to 30 kV and/or currents of more than 10 A.

According to the invention, the semiconductor module comprises a plurality of semiconductor devices connected in series and arranged along a length direction of the semiconductor module; a carrier plate for carrying the semiconductor devices, the carrier plate extending along the length direction and a width direction; and a plurality of heat sinks for air cooling, the heat sinks being connected to the carrier plate, being in thermal contact with the semiconductor devices and protruding from the carrier plate in a height direction of the carrier plate.

The length direction, height direction and width direction may be orthogonal with respect to each other. It has to be understood that these directions are relative orientations of the semiconductor module and do not refer to an orientation of the semiconductor module in space and/or with respect to gravity.

The carrier plate comprises a printed circuit board, for electrically interconnecting the semiconductor devices and a support frame for mechanically supporting the components of the semiconductor module, such as the semiconductor devices and the substrate. The carrier plate may have a rectangular shape.

The heat sinks, which may be made of a thermally conducting material, such as metal, may have an interface for direct contact with the semiconductor devices and a radiation part, where heat exchange with air is possible. The heat sinks may be mechanically connected to the substrate and/or to the support frame. As the heat sinks, also the semiconductor devices may protrude from the carrier plate in the height direction. It may be that all electrical components and the heat sinks of the semiconductor module are arranged on the same side of the semiconductor module.

The semiconductor devices may be diodes and the semiconductor module may provide a passive switching device of a rectifier. The semiconductor devices may be and/or may comprise transistors and/or thyristors and the semiconductor module may provide an active switching device of a converter. Typically low-voltage semiconductors may be employed, which are usually cheaper than higher-rated semiconductors and which, over time, may keep falling faster in price.

According to the invention, the heat sinks comprise fins and the carrier plate comprises openings, which are designed such that a cooling air flow in the height direction through the openings passes along the fins. There are openings and/or air flow channels between the fins and the openings in the carrier plate lead into the openings between the fins. The openings between the fins extend in the height direction. In a view direction along the height direction onto the semiconductor module, the openings between the fins overlap with the openings in the carrier plate. In a view direction along the height direction onto the semiconductor module, the heat sink fin structure may substantially have the same shape as the corresponding opening in the carrier plate.

In the case of diodes, the semiconductor module may be seen as a diode module. The diodes may be arranged in series-connected cells wherein the one or more diodes of each cell are attached to a heat sink.

The fins and/or the air flow channels may be aligned substantially orthogonal to a main current flow direction through the semiconductor module. The carrier plate may have openings below the heat sink fins in order to allow air flow substantially orthogonal to the carrier plate and through these openings and through the openings between the fins of the heats.

According to an embodiment of the invention, the openings in the carrier plate overlap at least 80%, at least 90% or all of the openings between the fins. This overlap may be in a view direction along the height direction. It also may be that each heat sink has a dedicated opening in the carrier plate and/or that the dedicated opening in the carrier plate overlaps at least 80%, at least 90% or all of the openings between the fins of the heat sink.

According to the invention, the carrier plate comprises a printed circuit board to which the semiconductor devices are connected. Such a printed circuit board may comprise a substrate, which may be made of plastics material, and a metallization layer, which is structured to provide conductor lines for interconnecting the semiconductor devices.

According to the invention, at least a part of the openings in the carrier plate is provided by openings in the printed circuit board. For example, the printed circuit board may comprise a substantially rectangular shape with rectangular openings in edges running along the length direction.

According to the invention, the carrier plate comprises a support frame to which the printed circuit board is connected. The printed circuit board may be bolted, screwed and/or glued to the support frame. The support frame may have a substantially flat body with a rectangular shape. Both the printed circuit board and the support frame may be aligned in parallel to each other. The support frame also provides openings for substantially orthogonal air flow.

The printed circuit board together with the support frame are used as main structure for mechanical stability of the semiconductor module, wherein the printed circuit board also provides the air flow openings. Therefore, no additional parts are needed for cooling air guidance.

According to an embodiment of the invention, the support frame is made of an electrically insulating material, such as a plastics material. This may prevent eddy currents and/or may provide isolation standards. The support frame may provide insulation due to its material properties and/or may guarantee insulation distances to neighbouring semiconductor modules. The support frames may not only be used for providing mechanical support and for air flow guidance, but also to guarantee the required insulation distances.

According to the invention, at least a part of the openings in the carrier plate are provided by openings in the support frame. The openings in the support frame may be holes, which are surrounded by the material of the support frame. The openings in the support frame and the openings in the printed circuit boards may overlap.

According to an embodiment of the invention, the carrier plate and/or the support frame has two edges running in parallel to the length direction, in particular to insert the semiconductor module into an assembly box. The carrier plate provide a simple mechanism to put them into and/or remove them from their dedicated slot in the assembly box like a drawer for easy assembly and/or maintenance. The assembly box therefore may have grooves for receiving the edges.

According to an embodiment of the invention, the two edges have a different cross-section, in particular to prevent the insertion of the module into the assembly box in a wrong direction. For example, one edge (and the corresponding groove in the assembly box) may have a rectangular cross-section. The other edge (and the corresponding groove in the assembly box) may have a triangular cross-section.

According to an embodiment of the invention, the carrier plate has connectors at ends with respect to the length direction, which connectors are different, in particular to prevent the insertion of the module into a plug in the wrong direction. The connectors may be connected to the printed circuit board. The plug may be provided by an assembly box which provides slots for receiving semiconductor modules. With the grooves and/or the plugs, the assembly box may define the orientation of a semiconductor module inside the assembly box. The orientation may conform with a polarity of the semiconductor module.

According to an embodiment of the invention, the fins comprise plate fins, which extend in planes in parallel to the height direction. Between the plate fins, air flow channels are provided.

According to an embodiment of the invention, the fins comprise pin fins. This may allow a more whirled air flow may be generated.

According to an embodiment of the invention, each heat sink comprises a cooling interface in contact with at least one semiconductor device. The cooling interface may be a substantially flat part of the heat sink to which the one or more semiconductor devices are connected. The cooling interface may be parallel to the height direction.

According to an embodiment of the invention, the cooling interface is aligned orthogonal to the length direction. In this case, at least two semiconductor devices may be arranged in a row in parallel to the width direction and are in contact with one heat sink. This may result in a more compact semiconductor module with respect to the length direction.

According to an embodiment of the invention, the heat sinks are U-shaped. The legs of the U may extend besides the printed circuit board. The legs of the U may extend over openings in the support frame. The bottom of the U, which may comprise the cooling interface, may be aligned in parallel to the width direction.

According to an embodiment of the invention, the cooling interface is aligned in parallel to the length direction. In this case, semiconductor devices may be arranged in a row in parallel to the width direction wherein at least two semiconductor devices are in contact with one heat sink. This may result in a compact semiconductor module with respect to the width direction.

According to an embodiment of the invention, the heat sinks are comb-shaped, i.e. solely may have fins, which extend orthogonal in one direction from a flat cooling interface. The fins may extend besides the printed circuit board and/or over openings in the support frame.

According to an embodiment of the invention, a part of each heat sink protrudes over a border of the printed circuit board and/or extends over an opening of the support frame. In other words, the printed circuit board may be less width than the assembly of the components on it.

According to an embodiment of the invention, the semiconductor devices are diodes. In general, the semiconductor devices may comprise passive semiconductor switches, such as diodes, and/or active semiconductor switches, such as thyristors and transistors.

The semiconductor devices may be thyristors and optionally in addition with diodes.

The semiconductor devices may be transistors (such as IGBTs, MOSFETs, HEMTs) and optionally in addition with diodes.

According to an embodiment of the invention, the semiconductor module further comprises a plurality of equivalently designed semiconductor circuits, which are connected in series, each of which comprises at least one of the semiconductor devices. Each of the equivalently designed semiconductor circuits may be seen as a cell of the semiconductor module.

According to an embodiment of the invention, each semiconductor circuit and/or each cell comprises at least one of a resistor, a varistor, and a filter circuit connected in parallel to the at least one of the semiconductor devices. The filter circuit may comprise a series-connected resistor and capacitor. Each cell may provide components for voltage balancing and/or protection.

A further aspect of the invention relates to a converter assembly. The converter assembly provides electrical and mechanical connections for assembling a plurality of semiconductor modules into an electrical converter. It has to be understood that features of the semiconductor modules may be features of the converter assembly.

According to an embodiment of the invention, the converter assembly comprises an assembly box with a plurality of slots aligned in parallel to each other and a plurality of semiconductor modules such as described herein, which are arranged in the slots and/or inserted into the slots. The assembly box may comprise vertical walls aligned in parallel to the height direction and/or horizontal walls aligned in parallel to the width direction. There may be one slot per semiconductor module.

According to an embodiment of the invention, the semiconductor modules are electrically interconnected via the assembly box to form an electrical converter. There may be plugs at each end of a slot for receiving a connector of the semiconductor module inserted into the slot. These plugs may be electrically connected to form the electrical converter.

According to an embodiment of the invention, the semiconductor modules are aligned such that all their height directions are oriented in parallel and at least two semiconductor modules are stacked in the height direction with respect to each other. It may be that semiconductor modules for each phase of the converter (such as three) are stacked with respect to each other.

According to an embodiment of the invention, the assembly box comprises openings, such that a cooling air flow in height direction can pass through the semiconductor modules. The openings of the assembly box, which may be provided in the horizontal walls, may allow an air flow in height direction, i.e. orthogonal to a direction of the orientation of the carrier plate of the semiconductor module, i.e. the length and width direction. The air flow is oriented orthogonal to a direction of the main current flow, i.e. the length direction.

According to an embodiment of the invention, the assembly box comprises a fan box with fans for generating the air flow along the height direction. The fan box may be arranged on a top or bottom side of the assembly box. The fan box may be a mechanical structure on top or bottom for mounting fans which are aligned with air flow openings in the assembly box.

In general, the main air flow direction through the converter assembly is substantially orthogonal to the main current direction through the semiconductor modules in order to achieve a maximum fan utilization.

According to an embodiment of the invention, first semiconductor modules are aligned in first slots such that their length directions point towards a back wall of the assembly box and second semiconductor modules in second slots are aligned such that their length directions point away from the back wall. Semiconductor modules of different orientations may have a different polarity. In this way, the AC phase inputs of the electrical converter may be arranged on a front side of the assembly box and the DC inputs may be on a back side of the assembly box.

The length direction may be seen as a forward conducting direction or forward direction of a semiconductor module.

According to an embodiment of the invention, first plugs for receiving a first type of connector are provided at the back wall in the first slots and second plugs, designed differently to the first plugs, for receiving a second type of connector are provided at the back wall in the second slots. Specific plugs in the assembly box back wall in each slot may guarantee the correct insertion of each semiconductor module in terms of its orientation and/or forward direction.

The plugs inside the slots located at the back wall may be designed to enforce a specific electrical alignment of the semiconductor modules, which have according connectors that may be mounted on their printed circuit boards. For example, the electrical converter may be a rectifier, and the diodes on an upper phase branch and/or phase leg have an opposite forward direction than the diodes of a lower phase branch and/or phase leg.

According to an embodiment of the invention, the assembly box comprises vertical walls with two grooves in each slot for guiding two edges of a semiconductor module. The two grooves may be provided on the same height and on opposite walls of a slot. The grooves in the vertical walls are used to guide the insertion of the semiconductor modules.

According to an embodiment of the invention, the grooves may have a different cross-section. The grooves may be designed to enforce a specific electrical alignment of the semiconductor modules. For example, for a first semiconductor module in a first slot and a second semiconductor module in a second slot with opposite polarity and/or forward direction, the two grooves of the first slot may be arranged mirror symmetric to the two grooves of the second slot.

According to an embodiment of the invention, the assembly box is made from an insulating material, such as a plastics material. In particular, the vertical walls, the horizontal walls and the back wall may be made of insulating material. This may prevent eddy currents and may fulfil isolation standards.

According to an embodiment of the invention, the assembly box comprises vertical walls, which are aligned in parallel to the height direction. Not only the horizontal walls but also the vertical walls may comprise openings, which may be designed such that an air flow in width direction can leave the assembly box. These openings in the vertical walls result in an additional air flow to the sides of the converter assembly. Experiments have shown that the heat transport away from the semiconductor devices can be increased in this way.

According to an embodiment of the invention, the converter assembly comprises 6, 12, 18 or 24 semiconductor modules, which are electrically interconnected to form a 6-pulse, 12-pulse, 18-pulse, or 24-pulse inverter. In particular, all kinds of multi-pulse diode rectifier topologies, especially 6-pulse, 12-pulse, 18-pulse, may be provided by the converter assembly.

According to an embodiment of the invention, 3 semiconductor modules for each phase are stacked with respect to each other in height direction. This results in rows of 2, 4, 6 and 8 semiconductor modules in width direction for a 6-pulse, 12-pulse, 18-pulse, or 24-pulse inverter, respectively.

In summary, advantageous characteristics of the semiconductor modules and the converter assembly are: extreme high power density, very simple and robust design, low cost design, highly modular setup, replaceable parts, very simple and easy maintenance, scalable in term of voltage, current and pulse-number, rectangular shape and highly flexible form factor for optimum cabinet-fitting.

These and other aspects of the invention will be apparent from and elucidated with reference to the embodiments described hereinafter.

### BRIEF DESCRIPTION OF THE DRAWINGS

The subject-matter of the invention will be explained in more detail in the following text with reference to exemplary embodiments which are illustrated in the attached drawings.
Fig. 1 shows a circuit diagram of an electrical converter according to an embodiment of the invention.
Fig. 2 shows a circuit diagram of a semiconductor module according to an embodiment of the invention.
Fig. 3 schematically shows a perspective layout of an electrical converter according to an embodiment of the invention.
Fig. 4 shows a perspective view of a carrier plate of a semiconductor module according to an embodiment of the invention.
Fig. 5 shows a perspective view of the carrier plate of Fig. 4 equipped with electric components.
Fig. 6 shows a perspective view of a semiconductor module according to an embodiment of the invention.
Fig. 7 shows a top view of the semiconductor module of Fig. 7.
Fig. 8 shows a top view of a semiconductor module according to a further embodiment of the invention.
Fig. 9 shows a front view of a converter assembly according to a further embodiment of the invention.
Fig. 10 shows a top view of the converter of Fig. 9.
Fig. 11 shows a side view of the converter of Fig. 9.

The reference symbols used in the drawings, and their meanings, are listed in summary form in the list of reference symbols. In principle, identical parts are provided with the same reference symbols in the figures.

### DETAILED DESCRIPTION OF EXEMPLARY EMBODIMENTS

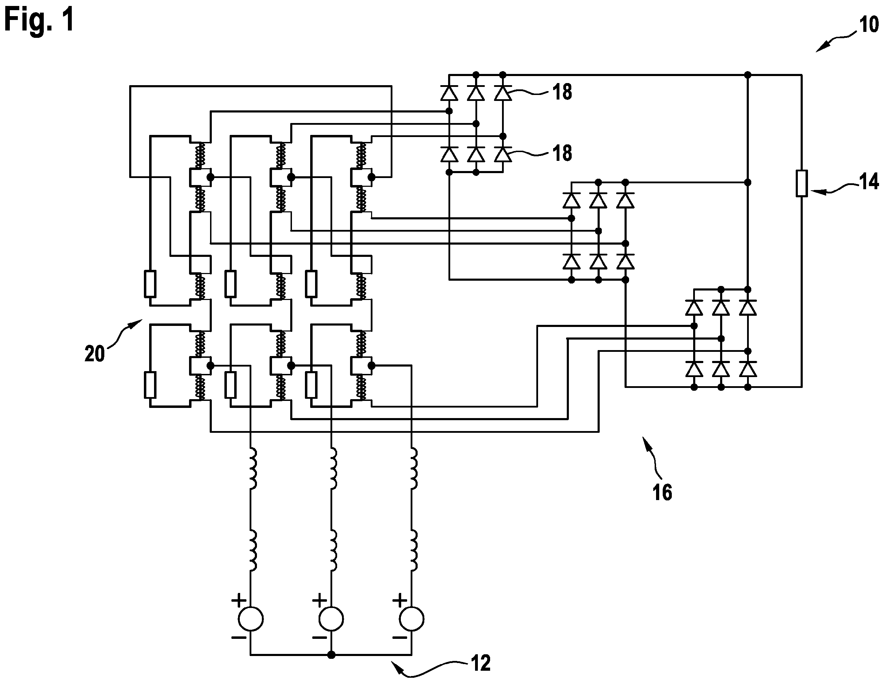

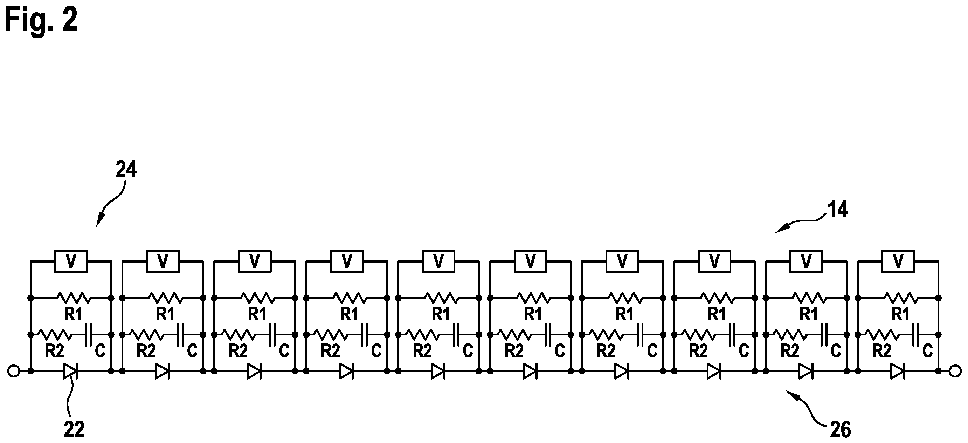

Fig. 1 shows a circuit diagram for an electrical converter system 10 interconnected between an AC source 12, such as an AC grid, and a DC load 14. As example, the electrical converter system 10 comprises an 18-pulse rectifier 16 with 18 phase branches 18, which are depicted with one diode symbol, but such as shown in Fig. 2 are composed of a plurality of series-connected diodes.

In multi-pulse configurations, like the 18-pulse rectifier 16, diode bridge rectifiers can already fulfill grid harmonic standards at comparably low cost, high efficiency, high compactness and high robustness. For unidirectional applications, which require several Megawatts of power and are connected to a medium voltage grid 12, like fast charging (for example electric vehicles, trucks, buses, ships and ferries, large drones), processing industry (for example H2-production), large drives for pumps and blowers and also data centers, very often 12-pulse diode rectifiers are employed together with according line-frequency 12-pulse transformers. In general, the rectifier 16 may be a 6-, 12-, 18- or 24-pulse rectifier.

It is also possible that not a rectifier 16 with passive semiconductor switches, but an inverter 16 with active semiconductor switches is used, which may be controlled for rectifying an AC voltage from the AC source 12 and/or for generating an AC voltage to be supplied to the AC source 12.

Fig. 1 furthermore shows that a line-interphase-transformer (LIT) 20 is interconnected between the AC source 12 and the rectifier 16. The LIT 20 provides a phase-shifted three-phase system without galvanic insulation. The LIT 20 may be used for to significantly reduce footprint, weight and cost of the rectifier. It is further possible to step down the voltage employing a medium frequency transformer in a second stage.

Fig. 2 shows a circuit diagram for one of the phase branches 18 of the rectifier 16.The phase branch 18 comprises a plurality (for example more than 5) series-connected semiconductor devices 22 (here diodes). In general, for an inverter 16 with active semiconductor switches, the semiconductor devices may be transistors or thyristors.

Each semiconductor device 22 is part of a cell 24, which besides the semiconductor devices 22 comprises a varistor V, a resistor R1 and a series-connection of a resistor R2 and a capacitor C connected in parallel. These components of the phase branch 18 form a passive balancing and protection network of the phase branch 18. It is possible that solely the resistor R1, solely the series-connection of the resistor R2 and the capacitor or solely the varistor V is present. Also combinations of these components are possible.

As example, a voltage from about 100 to 200 kV may be processed by the phase branch 18. This may result in the semiconductor devices 22 handling voltages between about 10 to 20 kV. A phase branch 18 may process currents between about 50 to 100 A.

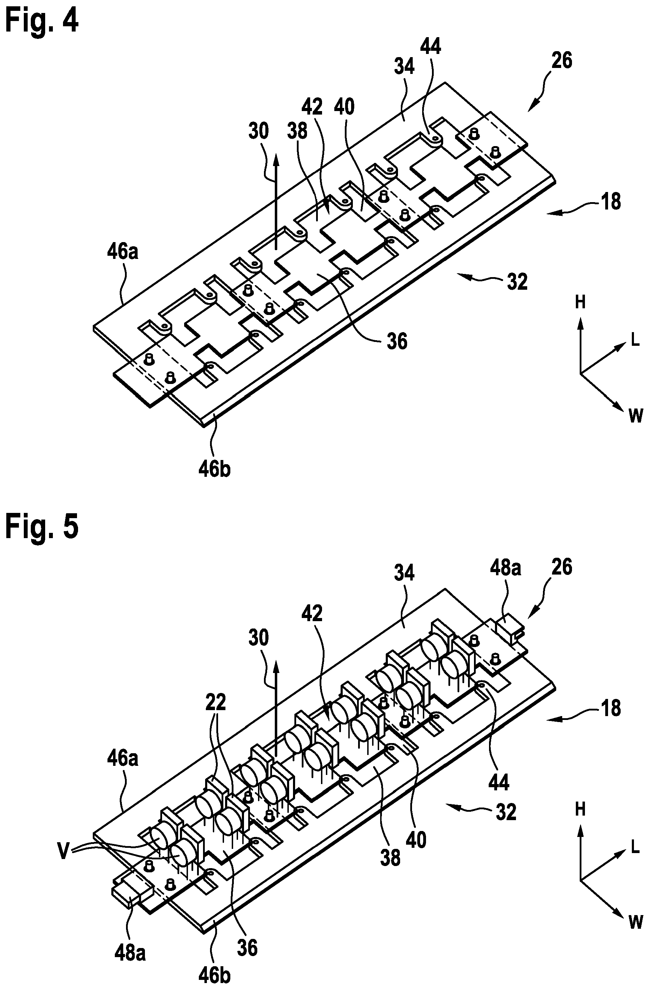

In the following, every phase branch 18 as shown in Fig. 2 is provided by a semiconductor module 26, examples of which will be described with respect to Fig. 4 to 8.

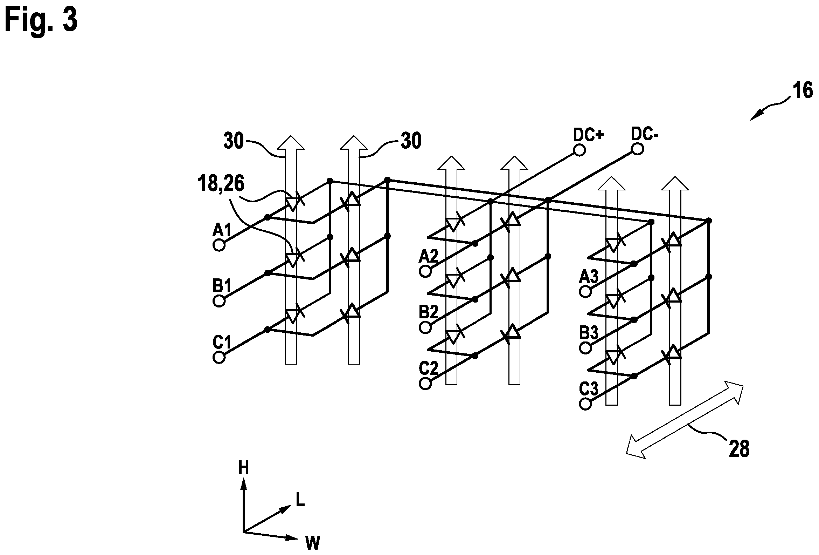

Fig. 3 shows a schematic perspective layout of an inverter 16 composed of 18 phase branches 18 provided by 18 semiconductor modules 26. In the following, an inverter 16 composed of semiconductor modules 26 with semiconductor devices 22 is described. However, it has to be understood that the semiconductor devices 22 may be diodes and the inverter 16 may be a rectifier. It also is possible that the semiconductor devices 22 are active semiconductor switches and that the inverter 16 can be actively controlled.

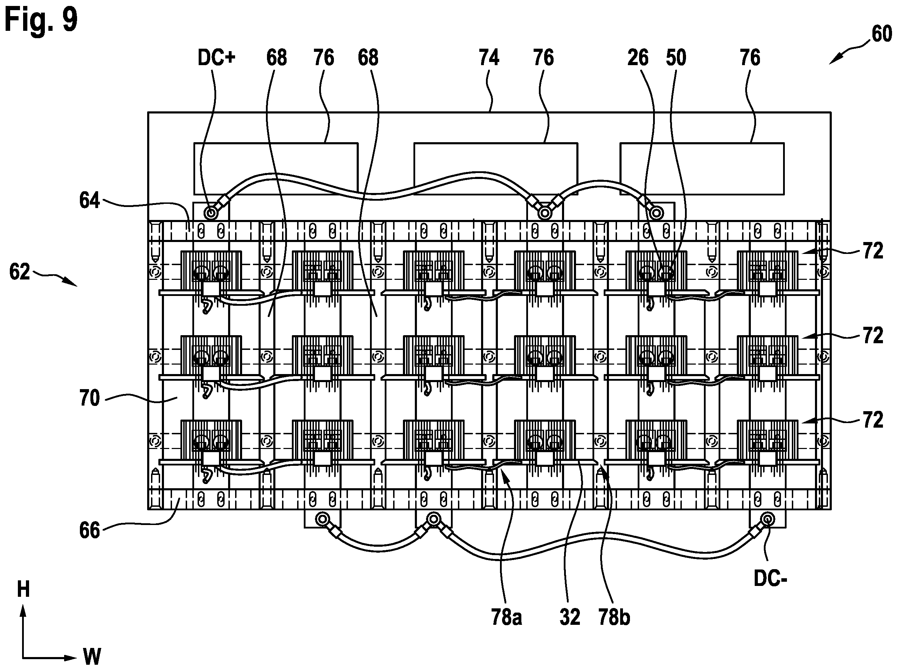

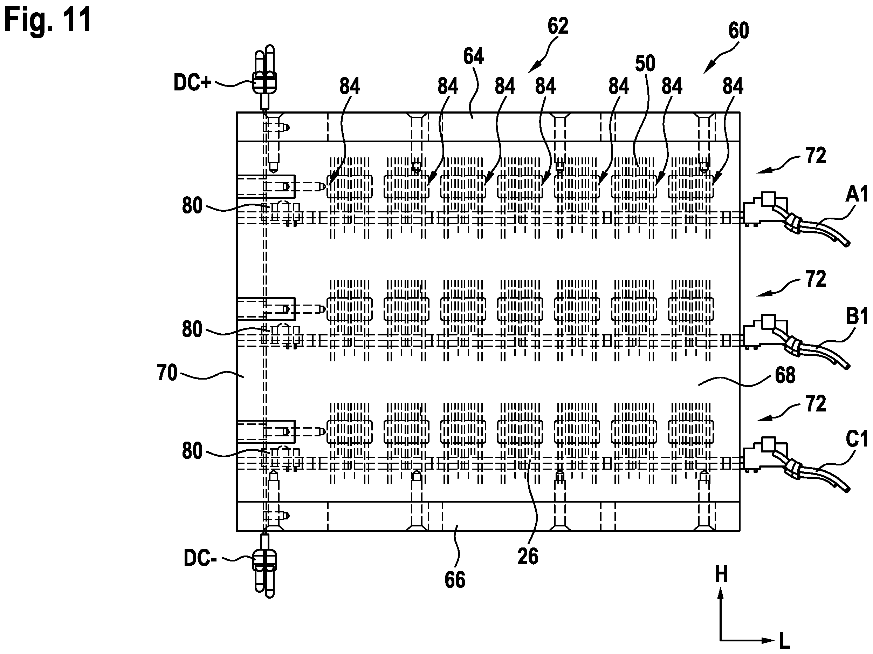

In general, each semiconductor module 26 has an orientation or forward direction, which is aligned in parallel or antiparallel to a length direction L of the semiconductor modules 26 and the inverter 16. Three of the semiconductor modules 26 are stacked with each other in a height direction H. These semiconductor modules 26 are connected on one side to an AC phase input A1, B1, C1 or A2, B2, C2 or A3, B3, C3 and on another side to the DC+ input or DC- input. The stacked semiconductor modules 26 are all oriented in the same direction and are all connected to the same DC input, DC+, DC-. The orientation in the width direction W is alternating. Half of the semiconductor modules 26 are row-wise mounted in opposing directions. The orientation of a semiconductor module 26 may be enforced by dedicated plugs at the back of slots, where the semiconductor modules 26 are inserted as will be explained with respect to Fig. 9-11. Also special grooves may enforce the orientation. The arrow 28 depicts a mounting movement of the semiconductor module 26 into the slots along the length direction L.

As will also be described with respect to the following figures, the semiconductor modules 26 have special openings and specially aligned heat sinks to allow an air flow 30 through the inverter 16 along the height direction H (substantially parallel or antiparallel to the height direction H). Thus, the air flow 30 is substantially orthogonal to a current flow, which is substantially in parallel (or antiparallel) to the length direction L.

Fig. 4-7 show a semiconductor module 26, which provides one of the phase legs 18, in different assembly stages.

Fig. 4 shows a carrier plate 32 of a semiconductor module 26, which comprises a support frame 34 and a printed circuit board 36, which is attached on top of the support frame 34. The attachment may be done with screws, bolts or glue.

The support frame 34 may be made of an electrically insulating material. This may guarantee the required insulation distance. Openings 38 in the support frame 34, which are surrounded by the material of the support frame 34 and openings 40 in the border of the printed circuit board 36, which overlap each other, generate openings 42 in the support frame 34, which allow an air flow 30 through the support frame 34 in height direction H.

As shown in Fig. 4, the support frame 34 also has protrusions 44 for supporting heat sinks.

Fig. 4 also shows that edges 46a, 46b of the support frame 34, which run in parallel to the length direction, have a different cross-section. Edge 46a has a rectangular cross-section, while edge 46b has a triangular cross-section. This is used for enforcing an orientation of the semiconductor module 26 in the inverter 16.

Fig. 5 shows the semiconductor module 26 with varistors V and semiconductor devices 22 mounted to the printed circuit board 36. The components V, 22 all protrude in the height direction from the printed circuit board 36. From a view direction in height direction, the components V, 22 do not overlap the openings 42 in the carrier plate 32.

Additionally, two connectors 48a, 48b are mounted to ends of the printed circuit board 36. The connectors 48a, 48b are of different type so as to enforce an orientation of the semiconductor module 26 in the inverter 16, when connected to a corresponding plug.

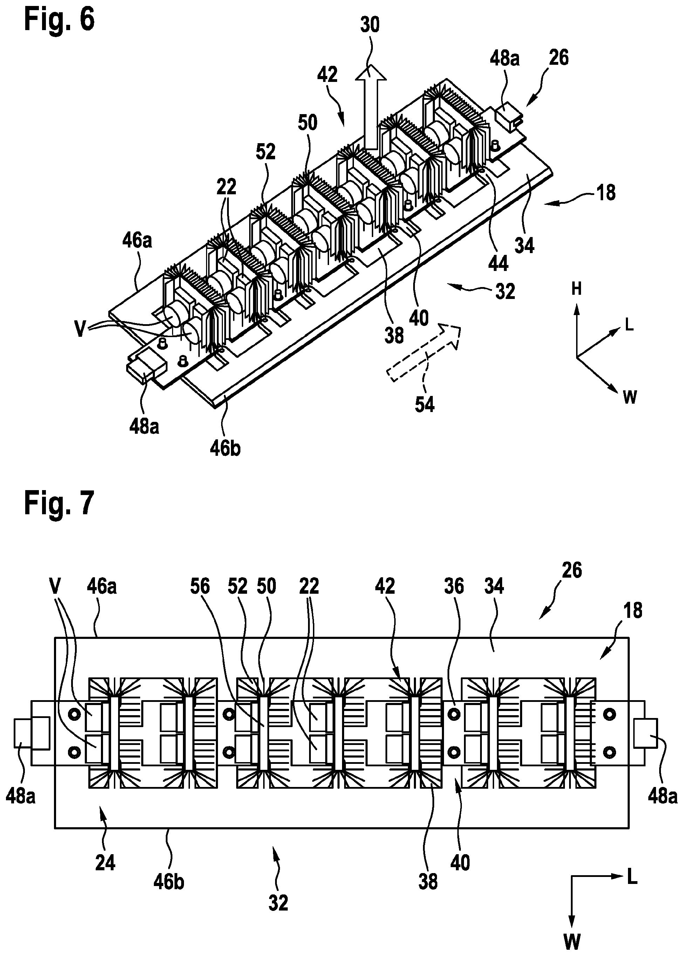

Fig. 6 shows additionally that heat sinks 50 are mounted to the carrier plate 32. The fins 52 of the heat sinks are aligned in parallel to the height direction H and in parallel to the air flow direction 30, which is substantially orthogonal to the current flow 54 in length direction.

Fig. 7 shows a top view in height direction onto the semiconductor module 26 as shown in Fig. 6. It can be seen that the heat sinks 50 have a cooling interface 56, which is aligned orthogonal to the length direction L and to which two semiconductor devices 22 are connected. There is one heat sink 50 per cell 24. The two semiconductor devices 22 of a cell 24 are arranged in a row along the width directions W. The same applies to the varistors V.

Every heat sink 50 is U-shaped, wherein the legs of the U and the fins 52 connected thereto are protruding beyond the border of the printed circuit board 36 and protrude over the opening 38, 42. The fins 52 connected to the bottom of the U are situated above the opening 40, 42.

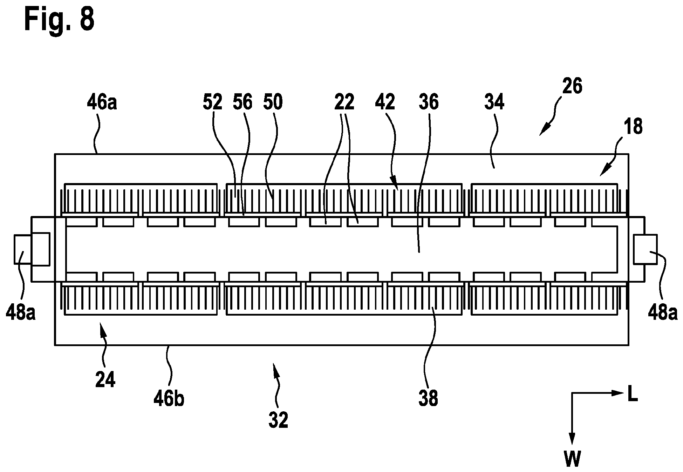

Fig. 8 shows a top view of further examples of a semiconductor module 26, said examples not being covered by the claimed invention. The printed circuit board 36 does not have air flow openings but is substantially rectangular. Solely the support frame 34 provides openings 38, 42.

The semiconductor devices 22 are aligned in two rows along edges of the printed circuit board 36 in length direction L. The heat sinks 50 have a cooling interface 56, which is aligned orthogonal to the width direction W and to which two semiconductor devices 22 are connected. There are two heat sinks 50 per cell 24.

Here, every heat sink 50 is comb-shaped, wherein the fins 52, which are aligned orthogonal to the length direction L, are protruding beyond the border of the printed circuit board 36 and protrude over the opening 38, 42.

Fig. 9, 10 and 11 show a converter assembly 60 in a cross-sectional front view, top view and side view. The converter assembly 60 comprises an assembly box 62 made of a horizontal top wall 64, a horizontal bottom wall 66, a back wall 70 and vertical walls 68. The assembly box 62 and in particular the walls 64, 66, 68 are made of an insulating material. As shown, the walls 64, 66, 68 may be interconnected by screwing. However, also other types of interconnections like bolts are possible.

The horizontal top wall 64 and the horizontal bottom wall 66 are orthogonal to the height direction H. The vertical walls 68 are orthogonal to the width direction W. The back wall 70 is orthogonal to the length direction L.

Between the walls 64, 66, 68, 70, slots 72 for receiving semiconductor modules 26 are formed inside the assembly box 62. In each slot 72, one semiconductor module 26 is accommodated. The semiconductor modules 26 are designed such as shown in Fig. 6 and 7. However, also other semiconductor modules 26, for example such as shown in Fig. 8, may be used.

The inverter formed from the semiconductor modules 26 is like the one shown in Fig. 1 and 3. The 18 semiconductor modules 26 in the assembly box 62 are electrically interconnected to form an 18-pulse inverter. As shown, each semiconductor module 26 may comprise 7 cells, such as shown in Fig. 6 to 8. However, other numbers of cells are possible.

At the back wall 70, the semiconductor modules 26 are electrically interconnected with a DC+ output and a DC- output and at the front side, the semiconductor modules 26 are electrically interconnected with AC inputs A1, A2, A3, B1, B2, B3, C1, C2, C3, such as shown in Fig. 3.

In the shown embodiment, the dimensions of the assembly box 62 are 6.9 x 2.9 x 3.4 dm = 68 dm³. For a 10 kV / 2 MW operation, this results in a power density of 29 kW/dm³. Other dimensions are possible.

Fig. 9 additionally shows schematically a top box 74 with fans 76, the fans 76 generating an air flow in parallel or antiparallel to the height direction H. The airflow passes through the semiconductor modules 26 and in particular through the heat sinks 50 of the semiconductor modules 26. Due to the openings 38 (see Fig. 6-8) in the support frames 34 of the semiconductor modules 26 and the alignment of the fins 52, the air flow can pass directly through the semiconductor modules 26.

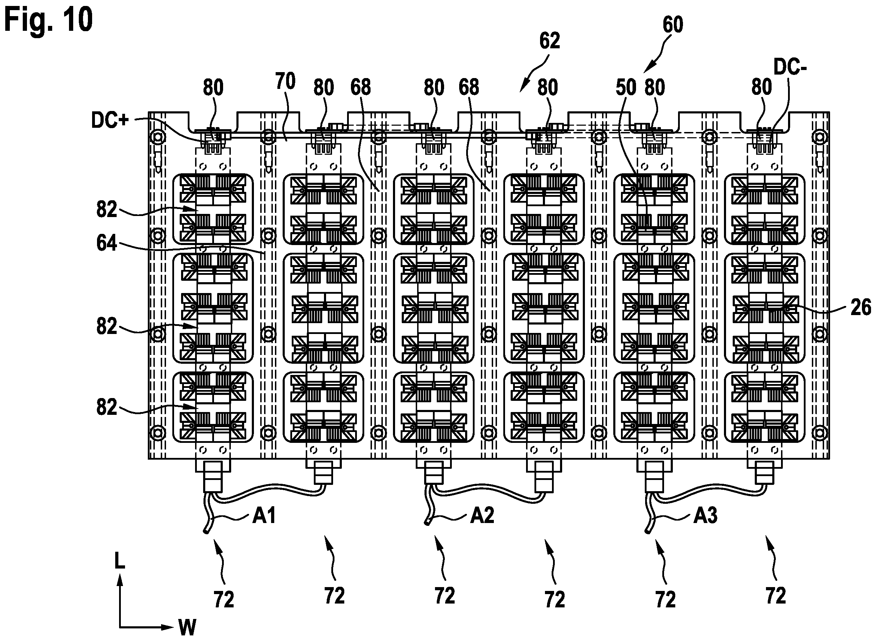

As best seen in Fig. 10, the semiconductor modules 26 have different orientations in the slots 72, either their length direction is aligned parallel to the length direction L of the assembly box 62 or their length direction is aligned anti-parallel to the length direction L of the assembly box 62. This is also shown in Fig. 3. The parallel aligned semiconductor modules 26 provide the upper branches of the inverter, which the anti-parallel aligned semiconductor modules 26 provide the lower branches.

The semiconductor modules 26 are designed exchangeable and there are grooves 78a, 78b provided in the vertical walls 68 for inserting the semiconductor modules 26 in a simple way. The grooves 78a, 78b of one slot 72 are designed to receive the edges 46a, 46b of the carrier plate 32 of the respective semiconductor module 26. To ensure the correct orientation, when exchanging one of the semiconductor modules 26, the two grooves 78a, 78b of one slot 72 are different. The grooves 78a have a rectangular cross-section, while the grooves 78b have a triangular cross-section. First semiconductor modules 26 are aligned in first slots 72 such that their length directions L point towards the back wall 70 of the assembly box 62 and second semiconductor modules 26 are aligned in second slots 72 such that their length directions L point away from the back wall 70.

As second measure for ensuring the correct orientation, plugs 80 are arranged at back wall 70. First plugs 80 for receiving a first type of connector 48a of the semiconductor modules 26 are provided at the back wall 70 in the first slots 72 and second plugs 80, designed differently to the first plugs 80, for receiving a second type of connector 48a are provided at the back wall 70 in the second slots 72.

For allowing an air flow through the assembly box 62, the assembly box 62 has openings 82 in the top wall 64 and in the bottom wall 66, such that a cooling air flow in height direction H can pass through the semiconductor modules 26. The fans 76 may be arranged above these openings 82. Additionally, the vertical walls 68 comprise openings 84, such that a cooling air flow in width direction W can leave the assembly box 62.

While the invention has been illustrated and described in detail in the drawings and foregoing description, such illustration and description are to be considered illustrative or exemplary and not restrictive; the invention is not limited to the disclosed embodiments. Other variations to the disclosed embodiments can be understood and effected by those skilled in the art and practising the claimed invention, from a study of the drawings, the disclosure, and the appended claims, provided that said variations fall within the scope of the invention, which is defined by the appended claims. In the claims, the word "comprising" does not exclude other elements or steps, and the indefinite article "a" or "an" does not exclude a plurality. A single processor or controller or other unit may fulfil the functions of several items recited in the claims. The mere fact that certain measures are recited in mutually different dependent claims does not indicate that a combination of these measures cannot be used to advantage. Any reference signs in the claims should not be construed as limiting the scope.

### LIST OF REFERENCE SYMBOLS

- 10: electrical converter system
- 12: AC source
- 14: DC load 14
- 16: rectifier, inverter
- 18: phase branches
- 20: line-interphase-transformer (LIT)
- 22: semiconductor device
- 24: cell
- V: varistor
- R1, R2: resistor
- C: capacitor
- 26: semiconductor module
- L: length direction
- H: height direction
- W: width direction
- A1, B1, C1: first AC phase inputs
- A2, B2, C2: second AC phase inputs
- A3, B3, C3: third AC phase inputs
- DC+: positive DC input
- DC-: negative DC input
- 28: mounting movement
- 30: air flow
- 32: carrier plate
- 34: support frame
- 36: printed circuit board
- 38: opening
- 40: opening
- 42: opening
- 44: protrusions
- 46a, 46b: edge
- 48a, 48b: electrical connector
- 50: heat sink
- 52: fin
- 54: current flow
- 56: cooling interface
- 60: converter assembly
- 62: assembly box
- 64: top wall
- 66: bottom wall
- 68: vertical wall
- 70: back wall
- 72: slot
- 74: top box
- 76: fan
- 78a, 78b: grooves
- 80: plug
- 82: opening
- 84: opening

## Claims

1. A semiconductor module (26), comprising:
a plurality of semiconductor devices (22) connected in series and arranged along a length direction (L) of the semiconductor module (26);
a carrier plate (32) for carrying the semiconductor devices (22), the carrier plate (32) extending along the length direction (L) and a width direction (W);
a plurality of heat sinks (50) for air cooling, the heat sinks (50) being connected to the carrier plate (32), being in thermal contact with the semiconductor devices (22) and protruding from the carrier plate (32) in a height direction (H) of the carrier plate (32);
wherein the heat sinks (50) comprise fins (52) and the carrier plate (32) comprises openings (42), such that a cooling air flow (30) in the height direction (H) through the openings (42) passes along the fins (52);
**characterized in that** the carrier plate (32) comprises a printed circuit board (36) to which the semiconductor devices (22) are connected and a support frame (34) to which the printed circuit board (36) is connected;
wherein at least a part of the openings (42) in the carrier plate (32) are provided by openings (40) in the printed circuit board (36) and at least a part of the openings (42) in the carrier plate (32) is provided by openings (38) in the support frame (34).

2. The semiconductor module (26) of claim 1,
wherein the openings (42) in the carrier plate (32) overlap at least 80% of openings between the fins (52).

3. The semiconductor module (26) of one of the previous claims,
wherein the carrier plate (32) has two edges (46a, 46b) running in parallel to the length direction (L) to insert the semiconductor module (26) into an assembly box (62);
wherein the two edges (46a, 46b) have a different cross-section to prevent the insertion of the semiconductor module (26) into the assembly box (62) in a wrong direction.

4. The semiconductor module (26) of one of the previous claims,
wherein the carrier plate (32) has connectors (48a, 48b) at ends with respect to the length direction (L), which connectors (48a, 48b) are different to prevent the insertion of the semiconductor module (26) into a plug (80) in a wrong direction.

5. The semiconductor module (26) of one of the previous claims,
wherein the fins (52) comprise plate fins, which extend in planes in parallel to the height direction (H); and/or
wherein the fins (52) comprise pin fins.

6. The semiconductor module (26) of one of the previous claims,
wherein each heat sink (50) comprises a cooling interface (56) in contact with at least one semiconductor device (22);
wherein the cooling interface (56) is aligned orthogonal to the length direction (L).

7. The semiconductor module (26) of one of the previous claims,
wherein each heat sink (50) comprises a cooling interface (56) in contact with at least one semiconductor device (22);
wherein the cooling interface (56) is aligned orthogonal to the width direction (W).

8. The semiconductor module (26) of one of the previous claims,
wherein the semiconductor devices (22) are diodes, or
wherein the semiconductor devices (22) are active semiconductor switches.

9. The semiconductor module (26) of one of the previous claims, further comprising:
a plurality of equivalently designed semiconductor circuits (24), which are connected in series, each of which comprises at least one of the semiconductor devices (22);
wherein each semiconductor circuit (24) comprises at least one of a resistor (R1), a varistor (V), and a filter circuit (R2, C) connected in parallel to the at least one of the semiconductor devices (22).

10. A converter assembly (60), comprising:
an assembly box (62) with a plurality of slots (72) aligned in parallel to each other;
a plurality of semiconductor modules (26) according to one of the previous claims, which are arranged in the slots (72);
wherein the semiconductor modules (26) are electrically interconnected via the assembly box (62) to form an electrical converter (16);
wherein the semiconductor modules (26) are aligned such that all their height directions (H) are oriented in parallel and at least two semiconductor modules (26) are stacked in the height direction (H) with respect to each other;
wherein the assembly box (62) comprises openings (82), such that a cooling air flow in height direction (H) can pass through the semiconductor modules (26).

11. The converter assembly (60) of claim 10,
wherein first semiconductor modules (26) are aligned in first slots (72) such that their length directions (L) point towards a back wall (70) of the assembly box (62) and second semiconductor modules (26) are aligned in second slots (72) such that their length directions (L) point away from the back wall (70).

12. The converter assembly (60) of claim 11,
wherein first plugs (80) for receiving a first type of connector (48a) are provided at the back wall in the first slots (72) and second plugs (80), designed differently to the first plugs (80), for receiving a second type of connector (48a) are provided at the back wall (70) in the second slots (72).

13. The converter assembly of claim 11 or 12,
wherein the assembly box (62) comprises vertical walls (68) with two grooves (78a, 78b) in each slot (72) for guiding two edges (46a, 46b) of a semiconductor module (26);
wherein the grooves (78a, 78b) have a different cross-section;
wherein the two grooves (78a, 78b) of a first slot (72) are arranged mirror symmetric to the two grooves (78a, 78b) of a second slot (72).

14. The converter assembly (60) of one of claims 10 to 13,
wherein the assembly box (62) is made from an insulating material.

15. The converter assembly (60) of one of claims 10 to 14,
wherein the assembly box (62) comprises vertical walls (68), which are aligned in parallel to the height direction (H);
wherein the vertical walls (68) comprise openings (84), such that a cooling air flow in width direction (W) can leave the assembly box (62).

16. The converter assembly (60) of one of claims 10 to 15,
wherein the converter assembly (60) comprises 6, 12, 18 or 24 semiconductor modules (26), which are electrically interconnected to form a 6-pulse, 12-pulse, 18-pulse, or 24-pulse inverter (16);
where 3 semiconductor modules (26) for each phase are stacked with respect to each other in height direction (H).

## Patentansprüche

1. Halbleitermodul (26), umfassend:
eine Vielzahl von Halbleitervorrichtungen (22), die in Reihe geschaltet sind und entlang einer Längsrichtung (L) des Halbleitermoduls (26) angeordnet sind;
eine Trägerplatte (32) zum Tragen der Halbleitervorrichtungen (22), wobei sich die Trägerplatte (32) entlang der Längsrichtung (1) und einer Breitenrichtung (W) erstreckt;
eine Vielzahl von Wärmesenken (50) für eine Luftkühlung, wobei die Wärmesenken (50) mit der Trägerplatte (32) verbunden sind, in einem thermischen Kontakt mit den Halbleitervorrichtungen (22) stehen und von der Trägerplatte (32) in einer Höhenrichtung (H) der Trägerplatte (32) hervorstehen;
wobei die Wärmesenken (50) Finnen (52) umfassen und wobei die Trägerplatte (32) Öffnungen (42) umfasst, sodass ein Kühlluftstrom (30) in der Höhenrichtung (H) durch die Öffnungen (42) entlang der Finnen (52) strömt;
**dadurch gekennzeichnet, dass** die Trägerplatte (32) eine gedruckte Leiterplatte (36), mit der die Halbleitervorrichtungen (22) verbunden sind, und einen Stützrahmen (34) umfasst, mit dem die gedruckte Leiterplatte (36) verbunden ist;
wobei mindestens ein Teil der Öffnungen (42) in der Trägerplatte (32) durch Öffnungen (40) in der gedruckten Leiterplatte (36) bereitgestellt werden und wobei mindestens ein Teil der Öffnungen (42) in der Trägerplatte (32) durch Öffnungen (38) in dem Stützrahmen (34) bereitgestellt werden.

2. Halbleitermodul (26) nach Anspruch 1,
wobei die Öffnungen(42) in der Trägerplatte (32) sich mit mindestens 80% der Öffnungen zwischen den Finnen (52) überschneiden.

3. Halbleitermodul (26) nach einem der vorhergehenden Ansprüche,
wobei die Trägerplatte (32) zwei Kanten (46a, 46b) aufweist, die parallel zur Längsrichtung (L) verlaufen, um das Halbleitermodul 26) in einen Montagekasten (62) einzufügen;
wobei die beiden Kanten (46a, 46b) unterschiedliche Querschnitte aufweisen, um das Einfügen des Halbleitermoduls (26) in einer falschen Richtung in den Montagekasten (62) zu vermeiden.

4. Halbleitermodul (26) nach einem der vorhergehenden Ansprüche,
wobei die Trägerplatte (32) an Enden in Bezug auf die Längsrichtung (L) Verbindungselemente (48a, 48b) aufweist, wobei die Anschlusselemente (48a, 48b) unterschiedlich sind, um das Einfügen des Halbleitermoduls (26) in einer falschen Richtung in einen Stecker (80) zu vermeiden.

5. Halbleitermodul (26) nach einem der vorhergehenden Ansprüche,
wobei die Finnen (52) Plattenfinnen umfassen, die sich in Ebenen parallel zur Höhenrichtung (H) erstrecken; und/oder
wobei die Finnen (52) Stiftfinnen umfassen.

6. Halbleitermodul (26) nach einem der vorhergehenden Ansprüche,
wobei jede Wärmesenke (50) eine Kühlgrenzfläche (56) in einem Kontakt mit mindestens einer Halbleitervorrichtung (22) umfasst;
wobei die Kühlgrenzfläche (56) senkrecht auf die Längsrichtung (L) ausgerichtet ist.

7. Halbleitermodul (26) nach einem der vorhergehenden Ansprüche,
wobei jede Wärmesenke (50) eine Kühlgrenzfläche (56) in einem Kontakt mit mindestens einer Halbleitervorrichtung (22) umfasst;
wobei die Kühlgrenzfläche (56) senkrecht auf die Breitenrichtung (W) ausgerichtet ist.

8. Halbleitermodul (26) nach einem der vorhergehenden Ansprüche,
wobei die Halbleitervorrichtungen (22) Dioden sind oder wobei die Halbleitervorrichtungen (22) aktive Halbleiterschalter sind.

9. Halbleitermodul (26) nach einem der vorhergehenden Ansprüche, das ferner umfasst:
eine Vielzahl von äquivalent ausgelegten Halbleiterschaltungen (24), die in Reihe geschaltet sind, wobei jede von diesen mindestens eine der Halbleitervorrichtungen (22) umfasst;
wobei jede Halbleiterschaltung (24) mindestens einen Widerstand (R1), einen Varistor (V) und eine Filterschaltung (R2, C) umfasst, die zu der mindestens einen der Halbleitervorrichtungen (22) parallel geschaltet sind.

10. Umrichterbaugruppe (60), umfassend:
einen Montagekasten (62) mit einer Vielzahl von Schlitzen (72) die parallel zueinander ausgerichtet sind;
eine Vielzahl von Halbleitermodulen (26) nach einem der vorhergehenden Ansprüche, die in den Schlitzen (72) angeordnet sind;
wobei die Halbleitermodule (26) über den Montagekasten (62) elektrisch miteinander verbunden sind, um einen elektrischen Umrichter (16) zu bilden;
wobei die Halbleitermodule (26) so ausgerichtet sind, dass alle ihre Höhenrichtungen (H) parallel zueinander ausgerichtet sind und mindestens zwei Halbleitermodule (26) in der Höhenrichtung (H) in Bezug zueinander gestapelt sind;
wobei der Montagekasten (62) Öffnungen (82) umfasst, sodass ein Kühlluftstrom in der Höhenrichtung (H) durch die Halbleitermodule (26) strömt.

11. Umrichterbaugruppe (60) nach Anspruch 10,
wobei erste Halbleitermodule (26) in ersten Schlitzen (72) so ausgerichtet sind, dass ihre Längsrichtungen (L) in Richtung auf eine Rückwand (70) des Montagekastens (62) weisen und wobei zweite Halbleitermodule (26) in zweiten Schlitzen (72) so ausgerichtet sind, dass ihre Längsrichtungen (L) von der Rückwand (70) weg weisen.

12. Umrichterbaugruppe (60) nach Anspruch 11,
wobei erste Stecker (80) zum Aufnehmen eines ersten Typs von Verbindungselementen (48a) an der Rückwand in den ersten Schlitzen (72) bereitgestellt werden und wobei zweite Stecker (80), die anders als die ersten Stecker gestaltet sind (80), zum Aufnehmen eines zweiten Typs von Verbindungselementen (48a) an der Rückwand (70) in den zweiten Schlitzen (72) bereitgestellt werden.

13. Umrichterbaugruppe nach Anspruch 11 oder 12,
wobei der Montagekasten (62) vertikale Wände (68) mit zwei Nuten (78a, 78b) in jedem Schlitz (72) umfasst, um zwei Kanten (46a, 46b) eines Halbleitermoduls (26) zu führen;
wobei die Nuten (78a, 78b) einen unterschiedlichen Querschnitt aufweisen;
wobei die beiden Nuten (78a, 78b) eines ersten Schlitzes (72) spiegelsymmetrisch zu den beiden Nuten (78a, 78b) eines zweiten Schlitzes (72) angeordnet sind.

14. Umrichterbaugruppe (60) nach einem der Ansprüche 10 bis 13,
wobei der Montagekasten (62) aus einem isolierenden Material gefertigt ist.

15. Umrichterbaugruppe (60) nach einem der Ansprüche 10 bis 14,
wobei der Montagekasten (62) vertikale Wände (68) umfasst, die parallel zu der Höhenrichtung (H) ausgerichtet sind;
wobei die vertikalen Wände (68) Öffnungen (84) umfassen, sodass ein Kühlluftstrom den Montagekasten (62) in einer Breitenrichtung (W) verlassen kann.

16. Umrichterbaugruppe (60) nach einem der Ansprüche 10 bis 15,
wobei die Umrichterbaugruppe (60) 6, 12, 18 oder 24 Halbleitermodule (26) umfasst, die elektrisch miteinander verbunden sind, um einen 6-Puls-, 12-Puls-, 18-Puls- oder 24-Puls-Wechselrichter (16) zu bilden; wobei für jede Phase 3 Halbleitermodule (26) in einer Höhenrichtung (H) in Bezug zueinander gestapelt werden.

## Revendications

1. Module semi-conducteur (26), comprenant :
une pluralité de dispositifs semi-conducteurs (22) connectés en série et agencés selon une direction de longueur (L) du module semi-conducteur (26) ;
une plaque porteuse (32) destinée à porter les dispositifs semi-conducteurs (22), la plaque porteuse (32) s'étendant selon la direction de longueur (L) et une direction de largeur (W) ;
une pluralité de dissipateurs thermiques (50) pour assurer un refroidissement par air, les dissipateurs thermiques (50) étant connectés à la plaque porteuse (32), étant en contact thermique avec les dispositifs semi-conducteurs (22) et faisant saillie hors de la plaque porteuse (32) dans une direction de hauteur (H) de la plaque porteuse (32) ;
les dissipateurs thermiques (50) comprenant des ailettes (52) et la plaque porteuse (32) comprenant des ouvertures (42), de sorte qu'un flux d'air de refroidissement (30) dans la direction de hauteur (H) à travers les ouvertures (42) s'écoule le long des ailettes (52) ;
**caractérisé en ce que** la plaque porteuse (32) comprend une carte de circuit imprimé (36) sur laquelle sont connectés les dispositifs semi-conducteurs (22) et un cadre de support (34) sur lequel est connecté la carte de circuit imprimé (36) ;
au moins une partie des ouvertures (42) dans la plaque porteuse (32) étant fournie par des ouvertures (40) dans la carte de circuit imprimé (36) et au moins une partie des ouvertures (42) dans la plaque porteuse (32) étant fournie par des ouvertures (38) dans le cadre de support (34).

2. Module semi-conducteur (26) selon la revendication 1,
dans lequel les ouvertures (42) dans la plaque porteuse (32) recouvrent au moins 80% des ouvertures entre les ailettes (52).

3. Module semi-conducteur (26) selon l'une des revendications précédentes,
dans lequel la plaque porteuse (32) présente deux bords (46a, 46b) s'étendant parallèlement à la direction de longueur (L) pour l'insertion du module semi-conducteur (26) dans un boîtier d'assemblage (62) ;
dans lequel les deux bords (46a, 46b) présentent une section transversale différente l'une de l'autre afin d'empêcher l'insertion du module semi-conducteur (26) dans le boîtier d'assemblage (62) dans le mauvais sens.

4. Module semi-conducteur (26) selon l'une des revendications précédentes,
dans lequel la plaque porteuse (32) présente, à des extrémités par rapport à la direction de longueur (L), des connecteurs (48a, 48b), les connecteurs (48a, 48b) étant différents afin d'empêcher l'insertion du module semi-conducteur (26) dans une prise (80) dans le mauvais sens.

5. Module semi-conducteur (26) selon l'une des revendications précédentes,
dans lequel les ailettes (52) comprennent des ailettes en plaque, s'étendant dans des plans parallèles à la direction de hauteur (H) ; et/ou
dans lequel les ailettes (52) comprennent des ailettes en broche.

6. Module semi-conducteur (26) selon l'une des revendications précédentes,
dans lequel chaque dissipateur thermique (50) comprend une interface de refroidissement (56) en contact avec au moins un dispositif semi-conducteur (22) ;
dans lequel l'interface de refroidissement (56) est alignée orthogonalement à la direction de longueur (L).

7. Module semi-conducteur (26) selon l'une des revendications précédentes,
dans lequel chaque dissipateur thermique (50) comprend une interface de refroidissement (56) en contact avec au moins un dispositif semi-conducteur (22) ;
dans lequel l'interface de refroidissement (56) est alignée orthogonalement à la direction de largeur (W).

8. Module semi-conducteur (26) selon l'une des revendications précédentes,
dans lequel les dispositifs semi-conducteurs (22) sont des diodes, ou
dans lequel les dispositifs semi-conducteurs (22) sont des interrupteurs semi-conducteurs actifs.

9. Module semi-conducteur (26) selon l'une des revendications précédentes, comprenant en outre :
une pluralité de circuits semi-conducteurs (24) de conception équivalente, connectés en série, dont chacun comprend au moins un des dispositifs semi-conducteurs (22) ;
dans lequel chaque circuit semi-conducteur (24) comprend une résistance (R1) et/ou une varistance (V) et/ou un circuit de filtrage (R2, C), connectés en parallèle avec l'au moins un des dispositifs semi-conducteurs (22).

10. Ensemble convertisseur (60), comprenant :
un boîtier d'assemblage (62) pourvu d'une pluralité de logements (72) alignés parallèlement les uns aux autres ;
une pluralité de modules semi-conducteurs (26) selon l'une des revendications précédentes, agencés dans les logements (72) ;
dans lequel les modules semi-conducteurs (26) sont interconnectés électriquement via le boîtier d'assemblage (62) afin de former un convertisseur électrique (16) ;
dans lequel les modules semi-conducteurs (26) sont alignés de sorte que toutes leurs directions de hauteur (H) sont orientées parallèlement et qu'au moins deux modules semi-conducteurs (26) sont empilés les uns par rapport aux autres dans la direction de hauteur (H) ;
dans lequel le boîtier d'assemblage (62) comprend des ouvertures (82), de sorte à permettre à un flux d'air de refroidissement dans la direction de hauteur (H) de s'écouler à travers les modules semi-conducteurs (26).

11. Ensemble convertisseur (60) selon la revendication 10,
dans lequel des premiers modules semi-conducteurs (26) sont alignés dans des premiers logements (72) de sorte que leurs directions de longueur (L) sont orientées vers une paroi arrière (70) du boîtier d'assemblage (62), et des deuxièmes modules semi-conducteurs (26) sont alignés dans des deuxièmes logements (72) de sorte que leurs directions de longueur (L) sont orientées à l'opposé de la paroi arrière (70).

12. Ensemble convertisseur (60) selon la revendication 11,
dans lequel des premières prises (80) destinées à recevoir un premier type de connecteur (48a) sont disposées au niveau de la paroi arrière dans les premiers logements (72) et des deuxièmes prises (80), de conception différente de celle des premières prises (80), destinées à recevoir un deuxième type de connecteur (48a), sont disposées au niveau de la paroi arrière (70) dans les deuxièmes logements (72).

13. Ensemble convertisseur selon la revendication 11 ou 12,
dans lequel le boîtier d'assemblage (62) comprend des parois verticales (68) pourvues de deux rainures (78a, 78b) dans chaque logement (72) destinées à guider deux bords (46a, 46b) d'un module semi-conducteur (26) ;
dans lequel les rainures (78a, 78b) présentent une section transversale différente l'une de l'autre ;
dans lequel les deux rainures (78a, 78b) d'un premier logement (72) sont agencées de manière symétrique en miroir par rapport aux deux rainures (78a, 78b) d'un deuxième logement (72).

14. Ensemble convertisseur (60) selon l'une des revendications 10 à 13,
dans lequel le boîtier d'assemblage (62) est réalisé en un matériau isolant.

15. Ensemble convertisseur (60) selon l'une des revendications 10 à 14,
dans lequel le boîtier d'assemblage (62) comprend des parois verticales (68), alignées parallèlement à la direction de hauteur (H) ;
dans lequel les parois verticales (68) comprennent des ouvertures (84), de sorte à permettre à un flux d'air de refroidissement dans la direction de largeur (W) de quitter le boîtier d'assemblage (62).

16. Ensemble convertisseur (60) selon l'une des revendications 10 à 15,
l'ensemble convertisseur (60) comprenant 6, 12, 18 ou 24 modules semi-conducteurs (26), interconnectés électriquement afin de former un onduleur (16) à 6 impulsions, 12 impulsions, 18 impulsions, ou 24 impulsions ;
3 modules semi-conducteurs (26) pour chaque phase étant empilés les uns par rapport aux autres dans la direction de hauteur (H).
